# EUROPEAN PATENT APPLICATION

(11) **EP 3 936 474 A1**
(43) Date of publication of application: **12.01.2022**
(21) Application number: 20769773.1
(22) Date of filing: 06.02.2020
(51) Int. Cl.: C01B 32/174, B82Y 10/00, B82Y 30/00, C01B 32/158, C01B 32/168, H01L 29/786, H01L 51/05, H01L 51/30

(54) **CARBON NANOTUBE COMPOSITION, SEMICONDUCTOR ELEMENT AND WIRELESS COMMUNICATION DEVICE**

(30) Priority: 08.03.2019 JP 2019042198; 24.07.2019 JP 2019136074
(71) Applicant: Toray Industries, Inc., Tokyo, 103-8666 (JP)
(72) Inventor: HIRAI, Takayoshi, Otsu-shi, Shiga 520-8558 (JP); NISHINO, Hidekazu, Otsu-shi, Shiga 520-8558 (JP); MURASE, Seiichiro, Otsu-shi, Shiga 520-8558 (JP)
(74) Representative: Hoefer & Partner Patentanwälte mbB
(86) International application number: PCT/JP2020/004611
(87) International publication number: WO 2020/184012

(57) **Abstract**

A carbon nanotube composition capable of producing an FET having improved mobility is provided. The carbon nanotube composition of the present invention is a halogen-free carbon nanotube composition comprising a carbon nanotube having the following features (1) and (2).
(1) A dispersion liquid obtained by dispersing the carbon nanotube in a solution containing a cholic acid derivative and water has, in the absorption spectrum in the wavelength range of 300 nm to 1100 nm measured by an ultraviolet/visible/near-infrared spectroscopy, the minimum absorbance in the range of 600 nm to 700 nm and the maximum absorbance in the range of 900 nm to 1050 nm; wherein the ratio of the minimum absorbance and the maximum absorbance is 2.5 or more and 4.5 or less; and
(2) the dispersion liquid has the height ratio of the G-band and the D-band (value of (D/G)×100) of 3.33 or less, as measured by a Raman spectrophotometer, using light having a wavelength of 532 nm as excitation light.

## Description

### TECHNICAL FIELD

The present invention relates to a carbon nanotube composition, and a semiconductor element and a wireless communication device in which the carbon nanotube composition is used.

### BACKGROUND ART

In recent years, field effect transistors (hereinafter referred to as FETs) using carbon nanotubes (CNTs) and organic semiconductors have been actively studied. In particular, CNTs have been receiving attention because CNTs are extremely stable in the atmosphere and are easier to handle compared to other semiconductor materials.

The CNTs have a tube structure in which a sheet of graphite is wound in a tubular shape. The chirality of CNTs changes depending on how the sheet of graphite is wound. CNTs having an individual chirality are roughly classified into semiconducting CNTs and metallic CNTs, according to the periodicity of the chirality. The mixing ratio of these CNTs is usually, regardless of the CNT synthesis method, semiconducting species: metallic species = 2:1. Therefore, when CNTs are used for FETs, it is common to increase the ratio of the semiconducting CNTs in order to improve the performance.

As a method of increasing the ratio of semiconducting CNTs, the metallic CNTs are often removed. As a method of removing the metallic CNTs, following methods are often used: an aqueous two-phase separation method (Patent Document 1) in which the difference in interaction with a surfactant is used, a density-gradient centrifugation method (Patent Document 2) in which the difference in the thickness (weight) of CNTs is mainly used for the separation, a gel column method (Patent Document 3) in which the difference in interaction of a polysaccharide gel and a surfactant with CNTs is used for separation, a method based on the difference in electrical properties (Patent Document 4) in which a voltage is applied to separate the semiconducting CNTs and the metallic CNTs, and the like. PRIOR ART

### DOCUMENTS

### PATENT DOCUMENTS

Patent Document 1: JP2018-168018A
Patent Document 2: US2011-0038786
Patent Document 3: JP2012-36041A
Patent Document 4 JP6212677B

### SUMMARY OF THE INVENTION

### PROBLEMS TO BE SOLVED BY THE INVENTION

In any of the separation methods of Patent Documents 1 to 4, it is necessary to disperse the CNTs in water before separating the semiconducting species and the metallic species. In any of the general dispersion methods for dispersing CNTs, the conductivity of CNTs deteriorates because the CNTs are damaged during the dispersion. As a result, the performance of the FET deteriorates, as well. On the other hand, when CNTs are less dispersed to alleviate the defects of the CNTs, the poor dispersion reduces the removal ratio of the metallic CNTs, and the FET performance decreases, too.

A CNT composition optimal for FETs, which has a high ratio of semiconducting CNTs (metallic CNTs are highly removed) and shows less damage due to the dispersion, has not been obtained at present.

In particular, the method of Patent Document 2 has a problem because the method results in a semiconducting CNT composition in which a halogen, which affects adversely the FETs, is mixed.

Therefore, one objective of the present invention is to provide a CNT which is capable of improving FET performance, in particular, mobility.

### SOLUTIONS TO THE PROBLEMS

That is, the present invention is a halogen-free carbon nanotube composition containing a carbon nanotube having the following features (1) and (2).
(1) A dispersion liquid obtained by dispersing the carbon nanotube in a solution containing a cholic acid derivative and water has, in the absorption spectrum in the wavelength range of 300 nm to 1100 nm measured by an ultraviolet/visible/near-infrared spectrophotometer, the minimum absorbance in the wavelength range of 600 nm to 700 nm and the maximum absorbance (εₘₐₓ) in the wavelength range of 900 nm to 1050 nm, wherein the ratio of the minimum absorbance (εₘᵢₙ) and the maximum absorbance (εₘₐₓ/εₘᵢₙ) is 2.5 or more and 4.5 or less; and
(2) the dispersion liquid has the height ratio of the G-band and the D-band (value of (D/G)×100) of 3.33 or less, as measured by a Raman spectrophotometer, using light having a wavelength of 532 nm as excitation light.

### EFFECTS OF THE INVENTION

By using the carbon nanotube composition of the present invention, an FET having improved mobility as compared with the conventional ones can be manufactured,

### BRIEF DESCRIPTION OF THE DRAWINGS

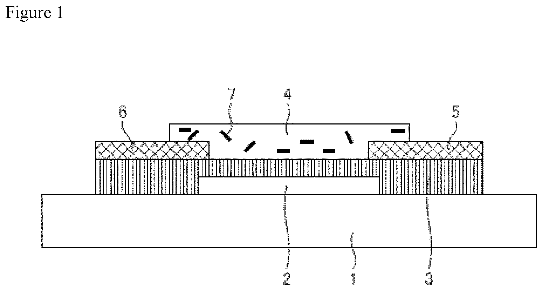

Fig. 1 is a schematic cross-sectional view of a semiconductor element according to one embodiment of the present invention.

### EMBODIMENTS OF THE INVENTION

The suitable embodiments of the carbon nanotube (CNT) composition of the present invention, and a semiconductor element and a wireless communication device in which the carbon nanotube composition is used are described in detail below. However, the present invention is not limited to the following embodiments and can be variously modified and implemented according to the purpose and application.

The CNT composition of the present invention contains a CNT having the following features (1) and (2) and does not contain halogen.
(1) A dispersion liquid obtained by dispersing the CNT in a solution containing a cholic acid derivative and water has, in the absorption spectrum in the wavelength range of 300 nm to 1100 nm measured by an ultraviolet/visible/near-infrared spectrophotometer, the minimum absorbance (εₘᵢₙ) in the wavelength range of 600 nm to 700 nm and the maximum absorbance (εₘₐₓ) in the wavelength range of 900 nm to 1050 nm, wherein the ratio of the minimum absorbance and the maximum absorbance (εₘₐₓ/εₘᵢₙ) is 2.5 or more and 4.5 or less.
(2) The dispersion liquid has the height ratio of the G-band and the D-band (value of (D/G)×100) of 3.33 or less, as measured by a Raman spectrophotometer, using light having a wavelength of 532 nm as excitation light.

### (Feature (1))

The CNT used in the present invention is dispersed in a solution containing a cholic acid derivative and water. When the resulting dispersion liquid is measured for the absorption spectrum in the wavelength range of 300 nm to 1100 nm, using an ultraviolet/visible/near-infrared spectrophotometer, the minimum absorbance (εₘᵢₙ) is present in the wavelength range of 600 nm to 700 nm, and the maximum absorbance (εₘₐₓ) is present in the wavelength range of 900 nm to 1050 nm. Furthermore, the ratio of the minimum absorbance and the maximum absorbance (εₘₐₓ/εₘᵢₙ) is 2.5 or more and 4.5 or less.

Usually, the absorption wavelength of absorption peak of CNT depends on the chirality. The wavelength range of 600 nm to 700 nm corresponds to the absorption region for the metallic CNTs, and the wavelength range of 900 nm to 1050 nm corresponds to the absorption region for the semiconducting CNTs. Therefore, the εₘₐₓ/εₘᵢₙ of 2.5 or more and 4.5 or less means that the ratio of the semiconducting CNTs is at a certain level. The higher εₘₐₓ/εₘᵢₙ is preferred because it means that the ratio of semiconducting CNTs is high. For example, the εₘₐₓ/εₘᵢₙ is preferably 2.8 or more and 4.5 or less, more preferably 3.0 or more and 4.5 or less, and still more preferably 4.0 or more and 4.5 or less. The upper limit of εₘₐₓ/εₘᵢₙ varies depending on the diameter distribution of CNTs. In the present invention, the upper limit is 4.5.

Further, the absorption peak present in the wavelength range of 900 nm to 1050 nm indicates that the diameter of the main component CNTs is in the range of 1.3 nm to 1.5 nm.

The cholic acid derivative is used as a dispersant for dispersing CNTs in a sample solution for measuring an absorption spectrum. One reason for using the cholic acid derivative is that the cholic acid derivative is a dispersant which can keep a stable dispersed state of CNTs without inhibiting the absorption by CNTs, can precisely represent the shape of the absorption spectrum, and can be easily removed upon the separation of CNTs from the dispersion liquid. Examples of more specific cholic acid derivatives that are readily available and can be suitably used include sodium cholate.

The method of dispersing CNTs is not particularly limited as long as the dispersion level allows for the measurement of the absorption spectrum, but an ultrasonic homogenizer is suitably used. Upon the dispersion, the concentration of the cholic acid derivative is preferably adjusted to about 0.4% by mass to 1.0% by mass. When a dispersion method other than the ultrasonic homogenizer is used, the dispersion time, intensity, and the concentration of the cholic acid derivative are appropriately adjusted according to the dispersion method.

The dispersion level that allows for the measurement of the absorption spectrum means a dispersed state in which the absorption spectrum can be measured within the absorption intensity range of 0.5 to 1.5 at a wavelength of 300 nm. When the absorption intensity is low, that is, when there are abundant bundled CNTs and the concentration of isolated and dispersed CNTs is low, it is necessary to lengthen the dispersion time or increase the dispersion intensity until the concentration of isolated and dispersed CNTs increases. On the other hand, when the concentration of CNTs becomes too high, the dispersion liquid can be diluted with an aqueous solution of cholic acid derivative while the concentration of the cholic acid derivative is maintained at 0.4% by mass to 1.0% by mass. Thus, the absorption intensity is adjusted to be within the above range.

### (Feature (2))

The CNTs used in the present invention has the height ratio of the G-band and the D-band (value of (D/G)×100) of 3.33 or less, when measured by a Raman spectrophotometer, using light having a wavelength of 532 nm as excitation light. The value of (D/G)×100 is rounded off to two decimal places. This state indicates that the crystallinity of the CNTs is high. The G band indicates the level of graphitization (crystallinity), and the D band indicates the abundance of CNT defects and edges, that is, the abundance of amorphous carbon. Therefore, the lower the value of (D/G)×100 is, the better the crystallinity of the CNT is, indicating less carbon impurities. Thus, the lower value of (D/G)×100 tends to result in better mobility of the FET. When the value of (D/G)×100 is 2.00 or less, the crystallinity is higher. When the value is 1.66 or less, the crystallinity is even higher. When the value is 1.25 or less, the CNTs have a high crystallinity with few impurities. The value of 1.00 or less is preferred because the crystallinity is the highest with few impurities.

The lower limit of the value of (D/G)×100 is not particularly limited because a lower value of (D/G)×100 is more preferred. From the viewpoint of the CNT dispersibility, the value of (D/G)×100 is preferably 0.5 or more, more preferably 0.67 or more, still more preferably 0.77 or more, and even more preferably 0.91 or more. When CNTs having very good dispersibility are used, the value of (D/G)×100 is particularly preferably 1.43 or more to disperse the CNTs without any damage.

Further, the level of crystallinity of CNTs and the amount of carbon impurities may be expressed by the height ratio of G band and D band as (G/D). The CNTs used in the present invention has the value of G/D of 30 or more, when measured by a Raman spectrophotometer, using light having a wavelength of 532 nm as excitation light. This state indicates that, as described above, the crystallinity of the CNT is high. The lower limit of G/D is preferably 40 or more, and more preferably 50 or more. The upper limit is preferably 200 or less, more preferably 150 or less, further preferably 130 or less, further preferably 110 or less, further preferably 100 or less, and still further preferably 70 or less. A higher G/D value indicates the better crystallinity of the CNTs. Therefore, a higher value of G/D tends to result in better mobility of the FET. Thus, although a higher value of G/D is better, in reality, the upper limit is about 200 at most. When the value is higher than 200, there are few carbon impurities, and the crystallinity of CNTs is too high, resulting in a strengthened cohesive force. This makes it difficult to use the CNTs in a dispersed state. Therefore, in order to maintain high mobility performance of the FET and to use easily the CNTs without its aggregation in the work process, the G/D is preferably 40 or more and 100 or less.

### (Feature (3))

The CNT composition according to the embodiments of the present invention does not contain halogen. This is because the contamination of a halogen such as iodine can change the properties of CNTs by redox reactions.

The phrase "does not contain halogen" herein means that the halogen is 0.1 atomic% or less or is not detected when the elemental analysis of the CNT composition of the present invention is carried out by the following method. The halogen content of 0.1 atomic% or less can be confirmed by X-ray Photoelectron Spectroscopy (XPS).

### (CNT diameter)

The diameter of the CNTs used in the present invention is preferably 1.3 nm to 1.5 nm. As described above, the CNTs used in the present invention have a high ratio of semiconducting CNTs.

In general, semiconducting CNTs show the largest band gap when the diameter is about 1.2 nm to 1.3 nm, and the band gap becomes smaller when the diameter is 1.2 nm to 1.3 nm or more or and or less. Therefore, it is estimated that the on-current / off-current ratio (on/off ratio), which is one of the indexes of the performance of semiconductor characteristics, is optimal when the diameter of the CNTs is around 1.2 nm to 1.3 nm. However, a smaller diameter of CNTs can result in a larger surface area with respect to the mass, and a smaller diameter also causes a stronger cohesive force, resulting in difficulty in dispersion.

In the method of removing metallic CNTs to obtain a CNT composition having a high ratio of semiconducting CNTs, in many cases, raw material CNTs in which the CNTs having the target diameter are the main component are used to obtain the semiconducting CNTs having the target diameter.

However, CNTs with a diameter of about 1.2 nm to 1.3 nm are CNTs with a relatively small diameter, and it is difficult to disperse them. Thus, it is not possible to achieve both the dispersibility sufficient to separate semiconducting species and metallic species at a high level, and the maintenance of high crystallinity without impairing the characteristics of CNTs.

Therefore, raw material CNTs containing as a main component CNTs with a diameter in the range of 1.3 nm to 1.5 nm are preferably used because relatively good dispersibility can be obtained. In addition, this is preferred also because a CNT composition having a high ratio of semiconducting CNTs can be obtained by the gel column method.

In the absorption spectrum of the CNT composition of the present invention, an absorption peak appears in a range corresponding to a diameter of 1.3 nm to 1.5 nm.

At present, there is no technique for 100% completely isolating and dispersing raw material CNTs without damaging the CNTs, and thus it is difficult to accurately verify the diameter distribution of raw material CNTs. According to the peak position in the absorption spectrum of the CNT composition of the present invention, it is considered that a raw material having a main diameter of about 1.3 to 1.5 nm in the diameter distribution is suitably used in order to obtain the CNT composition of the present invention.

An FET element was produced using the CNT composition of the present invention, and the mobility, which is one of the transistor performances, was measured. It was discovered that an element more high-performing than that from CNTs having a diameter of about 1.2 nm to 1.3 nm could be produced.

Although the exact cause has not been clarified, the reason for the improved mobility in the CNT composition of the present invention is believed to be several factors in combination including: the use of the raw material CNTs having the diameter corresponding to the highly dispersible region, which led to the reduced damage of the CNTs upon dispersion and to a CNT composition with a high ratio of semiconductors with few defects; the improved dispersibility which led to better performance of separation of semiconducting CNTs from metallic CNTs; the combination with the gel column method which resulted in a highly pure CNT composition, and the like.

The diameter of the raw material CNTs to be used can be confirmed as follows, for example. Using a transmission electron microscope that can confirm the diameter of a single CNT, raw material CNTs are observed to measure the recognizable diameters of 100 CNTs or more. The arithmetic mean can be obtained and used as a guide. Another method is to measure the light absorption of a raw material CNT dispersion liquid. The wavelength of the absorption peak showing the highest absorbance is determined and compared with the energy distribution of the Kataura plot to confirm the diameter of the CNTs mainly contained.

### (Gel Column Method)

The conditions of the gel column method need to be adjusted depending on the raw material CNTs to be used. Currently available CNTs are difficult to obtain in a state in which the physical characteristics such as the amount of impurities, the diameter distribution, and the aggregation level in the initial state are constantly stable because the synthetic technology in today's world is still immature. Therefore, the quality is corrected to some extent by purification or the like, and the portions which cannot be completely corrected are handled by slight modifications of the conditions of the gel column method each time. The gel column method is performed under the basic conditions once to confirm the separation status. Then, minor modifications can be made to the conditions.

Patent Document 3 and references described in Patent Document 3 can be referred to for the basic device configuration, principle and column separation conditions of the gel column method. The efficient separation procedure and condition adjustment method are shown below.

First, the principle and procedure of the gel column method, which is the most basic for column separation, are outlined. Raw material CNTs are put into the column as a dispersion liquid in sodium dodecyl sulfonate (SDS) and then an aqueous solution of SDS is flowed as a mobile phase. Usually, only the metallic CNTs flow out and the semiconducting CNTs are adsorbed on the gel in the column. Next, an aqueous solution of sodium deoxycholate (DOC) or sodium cholate (SC) are flowed as a mobile phase of the column. Then, the semiconducting CNTs adsorbed on the gel are released from the gel and flowed out as the DOC dispersion liquid or SC dispersion liquid. This method of changing the composition of the mobile phase is referred to as Pattern 1.

However, a dispersion liquid of raw material CNTs in which all the CNTs are isolated and dispersed cannot be prepared by a normal CNT dispersion method. Therefore, the CNTs adsorbed on the gel are not only the semiconducting CNTs; some bundled metallic CNTs are also adsorbed on the gel, mixed with the semiconducting CNTs. Furthermore, a part of the semiconducting CNTs also flow out, caught in the bundles mainly occupied by the metallic CNTs. Therefore, CNTs with poor dispersibility results in poor separation efficiency.

Moreover, the raw material CNTs that can be usually used are aggregates of CNTs having various chiralities and having slightly different adsorption force to the gel. Therefore, in many cases, the semiconducting CNTs and the metallic CNTs are not simply and clearly adsorbed and separated. Furthermore, regarding the dispersibility that affects the separation performance of the gel column method, the dispersion by in the ultrasonic dispersion, which is currently the most widely used because of its high efficiency, causes some device errors even if the conditions are the same. Therefore, the conditions of the gel column method need to be adjusted each time depending on the type and the dispersed state of raw material CNTs. In addition, various column conditions are devised in order to remove metallic CNTs caught in the bundles and metallic CNTs which are mixed in the semiconducting species and are not clearly separated. The ideas for separation condition adjustment are shown below.

Improving the dispersibility of CNTs is also one of the strategies for easier separation. When SC is used instead of SDS as the dispersant for dispersing the raw material CNTs, the dispersibility of the raw material CNTs can be improved. However, since the composition of the surfactant in the dispersion liquid is the same as that of the eluate, the separation performance of the column is lower than that of the SDS dispersion liquid. Therefore, the following method has also been devised: the dispersion is carried out in a SC aqueous solution, but SDS is added to the CNT dispersion liquid upon introduction into the column. The CNT dispersion liquid having the SC/SDS mixture as the dispersion medium is charged, and the CNT elution force by SC contained in the dispersion medium is thus suppressed. Since the purity of the semiconducting CNTs that can be adsorbed on the gel changes according to the SC/SDS ratio of the dispersion medium, the ratio is preferably changed according to the prepared CNTs. As a basic idea, when the SDS ratio in the dispersion medium is increased, the amount of CNTs adsorbed on the gel increases, but the amount of accompanying metallic CNTs also increases. When metallic CNTs are abundant, the removal of all the metallic CNTs in a later process becomes more difficult. On the other hand, when the SC ratio is increased, CNTs are less likely to be adsorbed on the gel, meaning that the ratio of metallic CNTs caught in the semiconducting CNTs adsorbed on the gel decreases. Thus, the CNT composition having a high ratio of semiconducting CNTs can be more easily obtained, but the separation performance of the column tends to decrease due to the high SC ratio in the dispersion liquid. Therefore, it is necessary to find an appropriate SC/SDS mixing ratio according to the dispersibility of the raw material CNTs which are charged.

The method of adjusting the flow of the mobile phase is considered as follows. In many cases, with the semiconducting CNTs adsorbed on the gel, an SDS aqueous solution is flowed as the first mobile phase to allow only the metallic CNTs to flow out, and then an SC aqueous solution or a DOC aqueous solution is flowed as a mobile phase to release the adsorbed semiconducting CNTs. In this switching, instead of changing the type of mobile phase at once, the mobile phase is switched while the ratio is gradually changed. In this case, adsorbed metallic CNTs that are caught in the bundles with the semiconducting CNTs adsorbed on the gel are gradually removed according to the ratio of the metallic CNTs caught in the bundles. Thus, the metallic CNTs can be easily removed without reducing the yield of the semiconducting CNTs.
From the first mobile phase in which the ratio of SDS to SC is SDS: SC = 100: 0, the ratio of C is gradually increased while the ratio of SDS is gradually decreased at the same time, and finally the mobile phase with SDS: SC = 0: 100 eluates all the CNTs. This method of changing the composition of the mobile phase is referred to as Pattern 2.

As a method of gradually changing the ratio, the composition ratio of the mobile phase is changed step by step, such as SDS: SC = 100: 0, then 75:25, then 50:50, then 25:75, and then 0: 100. This method of changing the composition of the mobile phase is referred to as Pattern 3. There are also other methods such as a method in which a mobile phase is flowed step by step while a constant ratio is maintained for a certain period of time, and a method in which the composition is changed continuously like a gradation, without maintaining a constant composition. Which is better depends on the dispersed state of the raw material CNTs to be used. When the bundle diameter distribution and CNT length distribution are very wide, it is difficult to determine which ratio of the mobile phase improves the separation performance. Therefore, the separation can be performed more efficiently by changing the composition continuously like a gradation.

Another method of changing the composition of the mobile phase is to release the adsorbed semiconducting CNTs while the ratio of SDS in the mobile phase is kept constant. In this method, while the SDS concentration of the mobile phase that is first flowed to elute the metallic CNTs is kept constant, in order to release semiconducting CNTs, SC or DOC is added to the mobile phase, and the concentration of SC or DOC is gradually increased (referred to as Pattern 4). In this case, DOC is preferably used because DOC is more capable of releasing the semiconducting CNTs from the gel. The reason why DOC is more capable of releasing CNTs than SC is not clear, but it is thought that the difference in the number of hydroxyl groups affects the difference in the force of interaction with CNTs and the dispersion medium. The advantage of this method of changing the composition is that the aggregation of CNTs due to the change in the composition of the mobile phase can be reduced since the composition is changed in a way that the concentration of the surfactant as a whole is increased. However, since the change rate of the composition is small, the separation performance is lower than that of the previous methods.

Further, there is also a method in which an SDS aqueous solution and an SC aqueous solution are alternately and repeatedly flowed as a mobile phase. This method of changing the composition of the mobile phase is referred to as Pattern 5. In this method, the semiconducting CNTs are repeatedly adsorbed on and released from the gel, and in this repetition, the metallic CNTs that are caught and adsorbed on the gel are gradually removed. If it is difficult to flow the SDS aqueous solution and the SC aqueous solution alternately and repeatedly due to the equipment limitations such as the performance of the liquid feed pump and the length of the column, the CNT composition obtained by the gel column method can be again subjected to the gel column method.

There is also a method in which the SDS/SC mixture solution is first flowed as a mobile phase, and then the SC aqueous solution is flowed. The advantage of this method is that a CNT composition having a high ratio of semiconducting CNTs can be easily obtained because the amount of semiconducting CNTs that are initially adsorbed is reduced and the amount of metallic CNTs that are caught in the semiconducting CNTs and adsorbed is also reduced. This method of changing the composition of the mobile phase is referred to as Pattern 6.

As a developed version of Pattern 6, there is also another method in which SDS/SC mixture solution is used as the first mobile phase, and while the concentration of SDS/SC is kept constant, DOC is then added in the middle to the mobile phase to gradually increase the concentration of DOC. In this pattern, the composition change of the mobile phase is small, and the adsorbed semiconducting CNTs can be eluted by increasing the DOC having a stronger elution force for CNT than the SC. Therefore, the aggregation of CNTs due to the change in the composition of the mobile phase can be suppressed to the minimum, and a highly dispersible CNT solution can be easily obtained. This method of changing the composition of the mobile phase is referred to as Pattern 7.

Further, a method in which the above methods of changing the composition are partially combined can be also considered.

In general, the composition of the mobile phase is preferably changed after the metallic CNTs are completely flowed out because the accuracy of separation is improved.

The concentration of SDS and SC or DOC used in the mobile phase should be adjusted so that the total value of each concentration in the column is generally within the range of 0.5% by mass or more and less than 2.0% by mass. If the total concentration is lower than 0.5% by mass, the dispersion stability of CNTs cannot be maintained, resulting in the aggregation of CNTs. On the other hand, if the total concentration is 2.0% by mass or more, the surfactant is too abundant. As a result, the difference in the interaction of the surfactant and the gel with the CNTs is less likely to occur, and the separation performance is lowered.

If the removal of the metallic CNTs cannot be adjusted by the method of changing the flow or the composition of the mobile phase, it is also possible to divide the eluate solution into small portions and only use the portions where the metallic CNTs can be removed.

### (Length of CNTs)

The average length of CNTs is preferably 0.5 µm to 2.0 µm. This length is relatively long among CNTs that are dispersed to such an extent that the semiconducting CNTs and the metallic CNTs can be separated. It is presumed that the such long CNTs can be obtained because CNTs having a diameter corresponding to a relatively good dispersibility are used.

Generally, in an FET in which CNTs are used, longer CNTs result in better performance because there are less contacts, which cause contact resistances. In the present invention, the average length of CNTs is more preferably 0.6 µm to 2.0 µm, further preferably 0.7 µm to 2.0 µm, and even more preferably 1.0 µm to 2.0 µm.

In the present invention, one of the reasons why a CNT composition which can provide a FET having high mobility can be obtained is that the gel column method is used. Since the gel column method also functions as size exclusion chromatography, by adjusting the conditions, it is possible to eliminate short CNTs due to deterioration of transistor performance.

The conditions of the gel column method of removing short CNTs cannot be determined unconditionally because the conditions vary depending on how the mobile phase is flowed. However, in a solution obtained from a mobile phase with a constant composition, the length of CNTs is usually shorter in the latter half. The eluate solution in which the CNTs are dispersed are divided into several portions, and the length of the CNTs contained in each of the separated portions is measured with an AFM (atomic force microscope) or the like. In this way, the CNTs having the required length can be located.

The average length herein means an arithmetic mean of the lengths of 100 or more CNTs arbitrarily extracted. The term "100 or more" as used herein means the following case: as a method of extracting CNTs arbitrarily, an atomic force microscope, a scanning electron microscope, a transmission electron microscope, or the like is used to obtain an image of the measurement field at a magnification at which the length of the CNTs can be recognized; then, when the lengths of all the CNTs counted in the image are measured, the number of measured CNTs reaches 100 or more. When the lengths of all the CNTs counted in the image of the measurement field are measured, if the number of all the CNTs does not reach 100 or more, an additional field image is also measured and the lengths of all the CNTs counted in the additional image are measured and added to the previous measurement results. This additional counting is performed in the same manner until the total number reaches 100 or more. In order to eliminate the arbitrariness of the measurement, even if the number of counted CNTs reaches 100, the count is continued until all the CNTs counted in the image of the measurement field have been extracted.

### (CNT Composite)

The CNT composition of the present invention can be also effective when used as a CNT composite in which a conjugated polymer is attached to at least a part of the CNT surface. The use as a composite allows for the application as a semiconductor ink. Thus, the use as a semiconductor material having higher mobility than before is possible for a coated transistor. Since the CNT composite has at least CNTs and a conjugated polymer, the CNT composite is included in the CNT composition of the present invention.

By adhering a conjugated polymer to at least a part of the surface of the CNTs, the CNTs can be uniformly dispersed in a solution without impairing the high electrical properties of the CNTs. When a dispersion liquid in which CNTs are uniformly dispersed is used, a CNT film in which CNTs are uniformly dispersed can be produced by a coating method. This way, high semiconductor characteristics can be achieved.

The state in which a conjugated polymer is adhered to at least a part of the surface of the CNTs means that a part or the whole of the surface of the CNTs is coated with the conjugated polymer. It is presumed that the conjugated polymer can coat CNTs because the interaction occurs due to the overlap of the π-electron clouds from the conjugated structures of the two.

Whether or not the CNTs are coated with the conjugated polymer can be determined from the reflected color of the CNTs. The reflected color of the coated CNTs is different from that of the uncoated CNTs and is close to the reflected color of the conjugated polymer. Quantitatively, elemental analysis such as X-ray photoelectron spectroscopy (XPS) can be used to confirm the presence of deposits on CNTs and to measure the mass ratio of CNTs and deposits.

Examples of the method of adhering the conjugated polymer to the CNTs include (I) a method in which CNTs are added and mixed in the molten conjugated polymer, (II) a method in which the conjugated polymer is dispersed in a dispersion medium, and CNTs are added to this dispersion system and mixed, (III) a method in which CNTs are dispersed in advance in a dispersion medium by ultrasonic waves or the like, and the conjugated polymer is added to the dispersion system and mixed, and (IV) a method in which the conjugated polymer and CNTs are added to a dispersion medium, and this mixture system is irradiated with ultrasonic waves to mix the conjugated polymer and CNTs. In the present invention, any method may be used, and a plurality of the methods may be combined.

### (Conjugated Polymer)

In the present invention, the conjugated polymer refers to a compound in which the repeating unit has a conjugated structure and the degree of polymerization is 2 or more. Examples of the conjugated polymers include, but are not particularly limited to, polythiophene polymers, polypyrrole polymers, polyaniline polymers, polyacetylene polymers, poly-p-phenylene polymers, poly-p-phenylene vinylene polymers, and the like. As the conjugated polymer, a polymer having a single monomer unit is preferably used, but a block copolymer, random copolymer and graft copolymer in which different monomer units are copolymerized in blocks, copolymerized in a random way, and grafted, respectively, are also preferably used.

Among the conjugated polymers, a conjugated polymer containing a fluorene unit or a thiophene unit in the repeating unit is preferred from the viewpoint of easy adhesion to CNTs and easy formation of a CNT composite. Further, those containing in the repeating unit a condensed heteroaryl unit having a nitrogen-containing double bond in the ring are more preferred.

Examples of the condensed heteroaryl units having a nitrogen-containing double bond in the ring include thienopyrol, pyrrolothiazole, pyropyridazine, benzimidazole, benzotriazole, benzoxazole, benzothiazole, benzothiadiazole, quinoline, quinoxaline, benzotriazine, thienooxazole, thienopyridine, thienothiazine, thienopyrazine and the like. Of these, the benzothiadiazole unit or the quinoxaline unit is particularly preferred. When these units are contained, the adhesion between the CNTs and the conjugated polymer is increased, and the CNTs can be dispersed better.

In the present invention, the conjugated polymer has a side chain represented by the general formula (1).

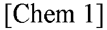

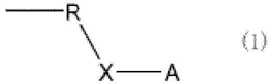

In the general formula (1), R is an alkylene group or a cycloalkylene group. X is a single bond, an alkenylene group, an alkynylene group, an arylene group or a heteroarylene group. A is an alkyl carbonyl group, an aryl carbonyl group, a heteroaryl carbonyl group, an alkoxy carbonyl group, an aryloxy carbonyl group, a heteroaryloxy carbonyl group, an alkyl carbonyloxy group, an aryl carbonyloxy group or a heteroaryl carbonyloxy group.

The CNT composite in which the conjugated polymer having a side chain represented by the general formula (1) is attached shows good dispersibility in a dispersion medium. In particular, this CNT composite disperses well in a dispersion medium having a viscosity of about 3 to 20 cP, which is suitable for inkjet coating. It is presumed that this is because the side chain represented by the general formula (1) changes the molecular motion of the conjugated polymer in the dispersion medium and thus improves compatibility with the dispersion medium having the suitable viscosity.

In order to enhance further the above effect, A is preferably an alkyl carbonyl group, an alkoxy carbonyl group, or an alkyl carbonyloxy group, and more preferably an alkoxy carbonyl group.

In the present specification, the alkylene group refers to a divalent (two bonding sites) saturated aliphatic hydrocarbon group, and examples thereof include an ethylene group, a propylene group, a butylene group, a hexylene group, and the like. The alkylene group may or may not have a substituent. The number of carbon atoms of the alkylene group is not specifically limited. From the viewpoint of the availability and cost, the number of carbon atoms of the alkylene group is preferably 1 or more and 20 or less, and more preferably, 1 or more and 8 or less.

The cycloalkylene group refers to a divalent saturated alicyclic hydrocarbon group, and examples thereof include a cyclopropylene group, a cyclobutylene group, a cyclopentalene group, a cyclohexylene group, and the like. The cycloalkylene group may or may not have a substituent. The number of carbon atoms of the cycloalkylene group is not specifically limited. From the viewpoint of the availability and cost, the number of carbon atoms of the cycloalkylene group is preferably 3 or more and 20 or less, and more preferably, 3 or more and 8 or less.

The alkenylene group refers to a divalent unsaturated aliphatic hydrocarbon group, and examples thereof include an ethenylene group, a propenylene group, a butenylene group, a hexenylene group, and the like. The alkenylene group may or may not have a substituent. The number of carbon atoms of the alkenylene group is not specifically limited. From the viewpoint of the availability and cost, the number of carbon atoms of the alkenylene group is preferably 2 or more and 20 or less, and more preferably, 2 or more and 8 or less.

The alkynylene group refers to a divalent unsaturated aliphatic hydrocarbon group, and examples thereof include an ethynylene group, a propynylene group, a butynylene group, a hexynylene group, and the like. The alkynylene group may or may not have a substituent. The number of carbon atoms of the alkynylene group is not specifically limited. From the viewpoint of the availability and cost, the number of carbon atoms of the alkynylene group is preferably 2 or more and 20 or less, and more preferably, 2 or more and 8 or less.

The arylene group refers to a divalent aromatic hydrocarbon group, and examples thereof include a phenylene group, a naphthylene group, a biphenylene group, a phenanthrylene group, an anthrylene group, a terphenylene group, a pyrenylene group, a fluorenylene group, a peryleneylene group, and the like. The arylene group may be unsubstituted or substituted. The number of carbon atoms of the arylene group is not particularly limited but is preferably in the range of 6 or more and 40 or less.

The heteroarylene group refers to a divalent heteroaromatic group, and examples thereof include, in addition to pyridylene group, pyrazylene group, quinolinylene group, isoquinolylene group, quinoxalylene group, acridinylene group, indolylene group, carbazolylene group and the like, divalent groups derived from heteroaromatic rings and the like such as benzofuran, dibenzofuran, benzothiophene, dibenzothiophene, benzodithiophene, benzosilole, and dibenzosilole. The heteroarylene group may be unsubstituted or substituted. The number of carbon atoms of the heteroarylene group is not particularly limited but is preferably in the range of 2 or more and 30 or less.

The alkyl carbonyl group refers to a functional group such as an acetyl group or a hexanoyl group, in which one group on the carbonyl bond is replaced with an aliphatic hydrocarbon group. The alkyl carbonyl group may or may not have a substituent. The number of carbon atoms of the alkyl carbonyl group is not particularly limited but is preferably in the range of 2 or more and 20 or less.

The aryl carbonyl group refers to a functional group such as a benzoyl group, in which one group on the carbonyl bond is replaced with an aromatic hydrocarbon group. The aryl carbonyl group may or may not have a substituent. The number of carbon atoms of the aryl carbonyl group is not particularly limited but is preferably in the range of 6 or more and 40 or less.

The heteroaryl carbonyl group refers to a functional group in which one group on the carbonyl bond is replaced with a heteroaromatic group. The heteroaryl carbonyl group may or may not have a substituent. The number of carbon atoms of the heteroaryl carbonyl group is not particularly limited but is preferably in the range of 2 or more and 30 or less.

The alkoxy carbonyl group refers to a functional group such as a methoxy carbonyl group, in which one group on the carbonyl bond is replaced with an alkoxy group. The alkoxy carbonyl group may or may not have a substituent. The number of carbon atoms of the alkoxy carbonyl group is not particularly limited but is preferably in the range of 2 or more and 20 or less.

The aryloxy carbonyl group refers to a functional group such as a phenoxy carbonyl group, in which one group on the carbonyl bond is replaced with an aryloxy group. The aryloxy carbonyl group may or may not have a substituent. The number of carbon atoms of the aryloxy carbonyl group is not particularly limited but is preferably in the range of 6 or more and 40 or less.

The heteroaryloxy carbonyl group refers to a functional group in which one group on the carbonyl bond is replaced with a heteroaryloxy group. The heteroaryloxy carbonyl group may or may not have a substituent. The number of carbon atoms of the heteroaryloxy carbonyl group is not particularly limited but is preferably in the range of 2 or more and 30 or less.

The alkyl carbonyloxy group refers to a functional group such as an acetoxy group, in which one group on the ether bond is replaced with an alkyl carbonyl group. The alkyl carbonyloxy group may or may not have a substituent. The number of carbon atoms of the alkyl carbonyloxy group is not particularly limited but is preferably in the range of 2 or more and 20 or less.

The aryl carbonyloxy group refers to a functional group such as a benzoyloxy group, in which one group on the ether bond is replaced with an aryl carbonyl group. The aryl carbonyloxy group may or may not have a substituent. The number of carbon atoms of the aryl carbonyloxy group is not particularly limited but is preferably in the range of 6 or more and 40 or less.

The heteroaryl carbonyloxy group refers to a functional group in which one group on the ether bond is replaced with a heteroaryl carbonyl group. The heteroaryl carbonyloxy group may or may not have a substituent. The number of carbon atoms of the aryl carbonyloxy group is not particularly limited but is preferably in the range of 2 or more and 30 or less.

In the above description, the alkyl group refers to a saturated aliphatic hydrocarbon group, and examples thereof include a methyl group, an ethyl group, an n-propyl group, an isopropyl group, an n-butyl group, a sec-butyl group, a tert-butyl group and the like. The alkyl group may or may not have a substituent. The number of carbon atoms of the alkyl group is not specifically limited. From the viewpoint of the availability and cost, the number of carbon atoms of the alkyl group is preferably 1 or more and 20 or less, and more preferably, 1 or more and 8 or less.

Examples of the aromatic hydrocarbon group include a phenyl group, a naphthyl group, a biphenyl group, an anthracenyl group, a phenanthryl group, a terphenyl group, a pyrenyl group, a fluorenyl group and the like. The aromatic hydrocarbon group may or may not have a substituent. The number of carbon atoms of the aromatic hydrocarbon group is not particularly limited but is preferably in the range of 6 or more and 40 or less.

The heteroaromatic group refers to an aromatic group having one or more atoms other than carbon in the ring, and examples thereof include a furanyl group, a thiophenyl group, a benzofuranyl group, a dibenzofuranyl group, a pyridyl group, a quinolinyl group, a benzosilole group, a dibenzosilole group, and the like. The heteroaromatic group may or may not have a substituent. The number of carbon atoms of the heteroaromatic group is not particularly limited but is preferably in the range of 2 or more and 30 or less.

The alkoxy group refers to a functional group in which one group on the ether bond is replaced with an alkyl group, and examples thereof include a methoxy group, an ethoxy group, a propoxy group, and the like. The alkoxy group may or may not have a substituent. The number of carbon atoms of the alkoxy group is not particularly limited but is preferably in the range of 1 or more and 20 or less.

The aryloxy group refers to a functional group in which one group on the ether bond is replaced with an aromatic hydrocarbon group, and examples thereof include a phenoxy group, a naphthoxy group, and the like. The aryloxy group may or may not have a substituent. The number of carbon atoms of the aryloxy group is not particularly limited but is preferably in the range of 6 or more and 40 or less.

The heteroaryloxy group refers to a functional group in which one group on the ether bond is replaced with a heteroaromatic group. The heteroaryloxy group may or may not have a substituent. The number of carbon atoms of the heteroaryloxy group is not particularly limited but is preferably in the range of 2 or more and 30 or less.

Specific examples of conjugated polymers preferably used in the present invention include those having the following structure. However, the conjugated polymers used in the present invention are not limited to these.

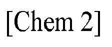

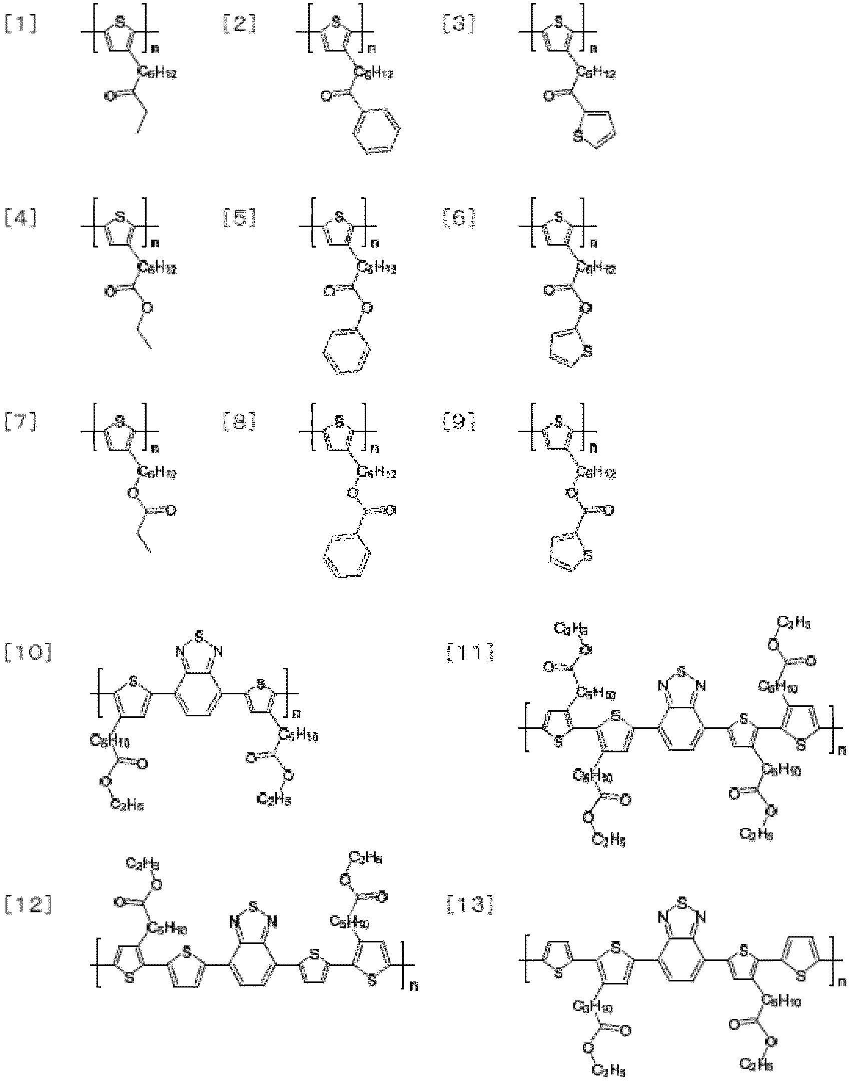

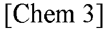

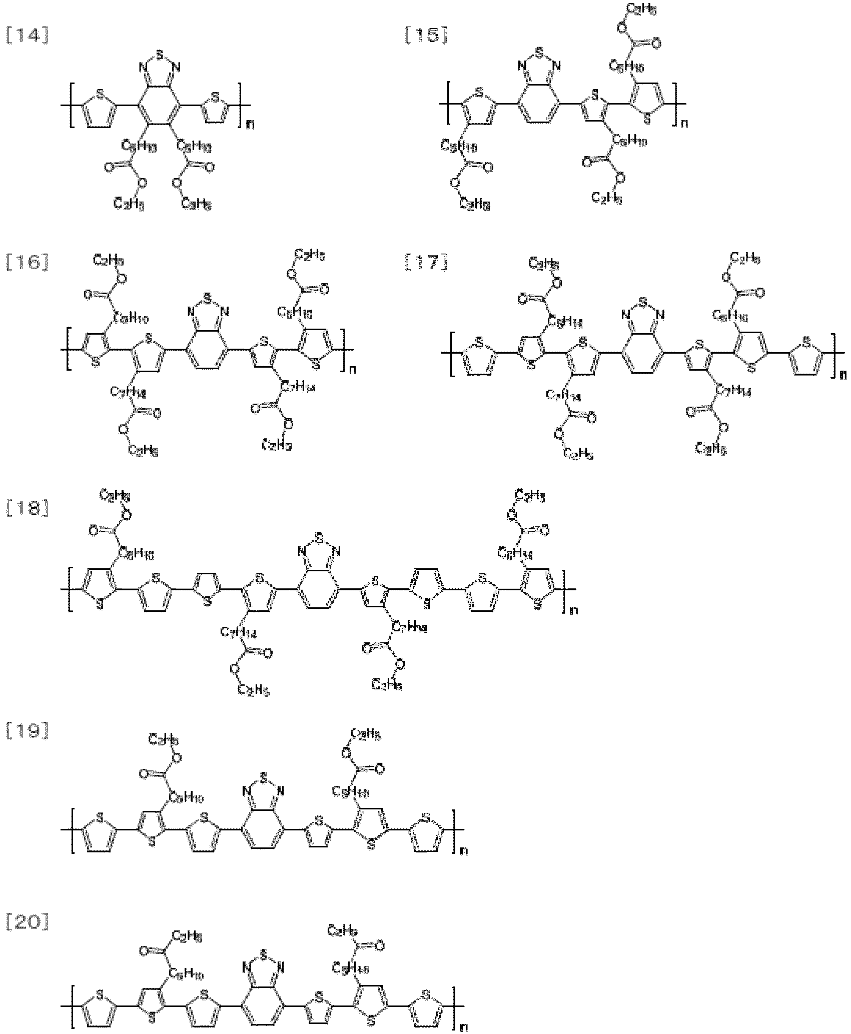

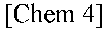

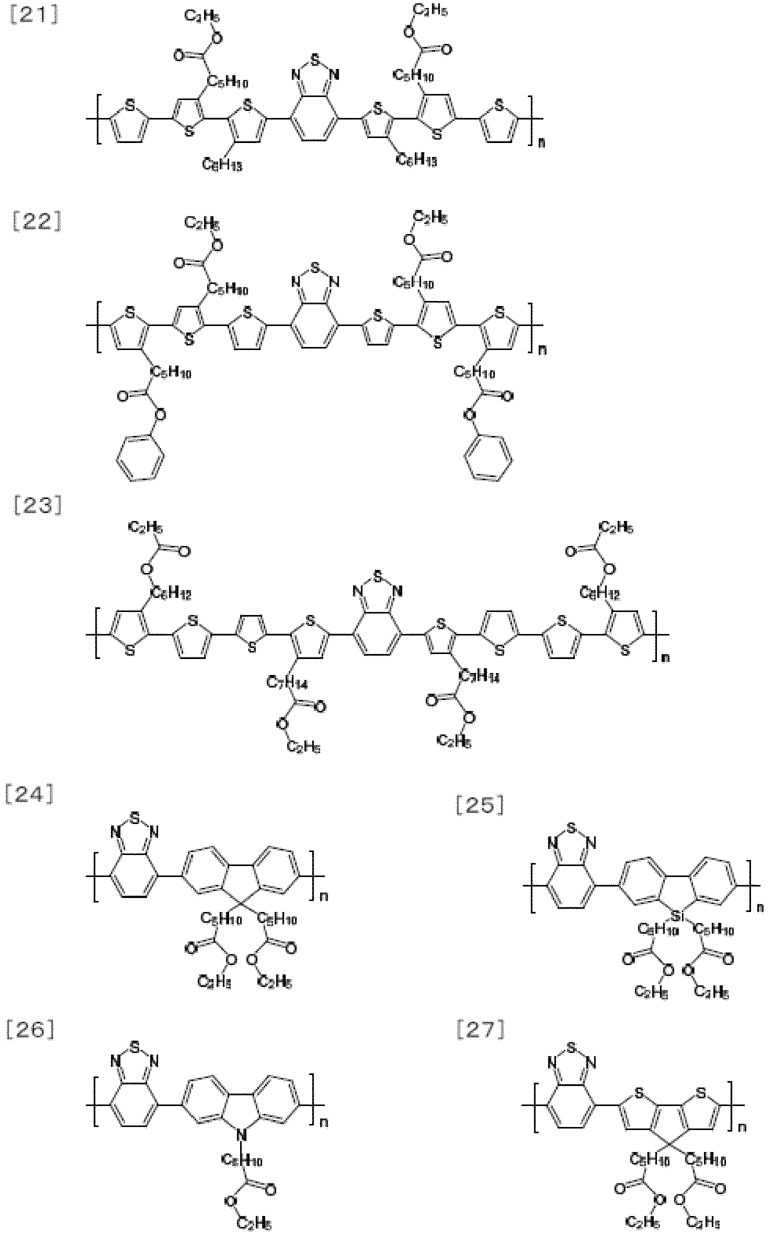

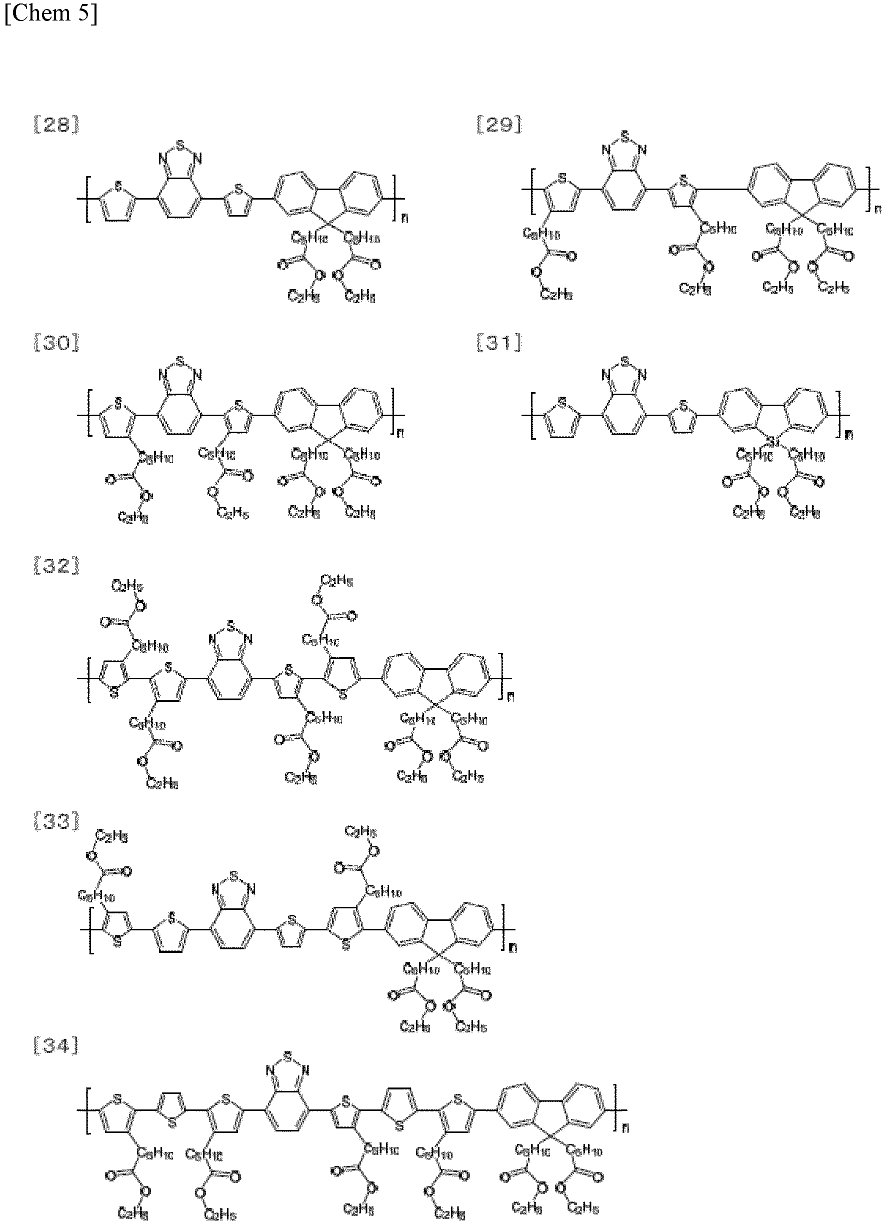

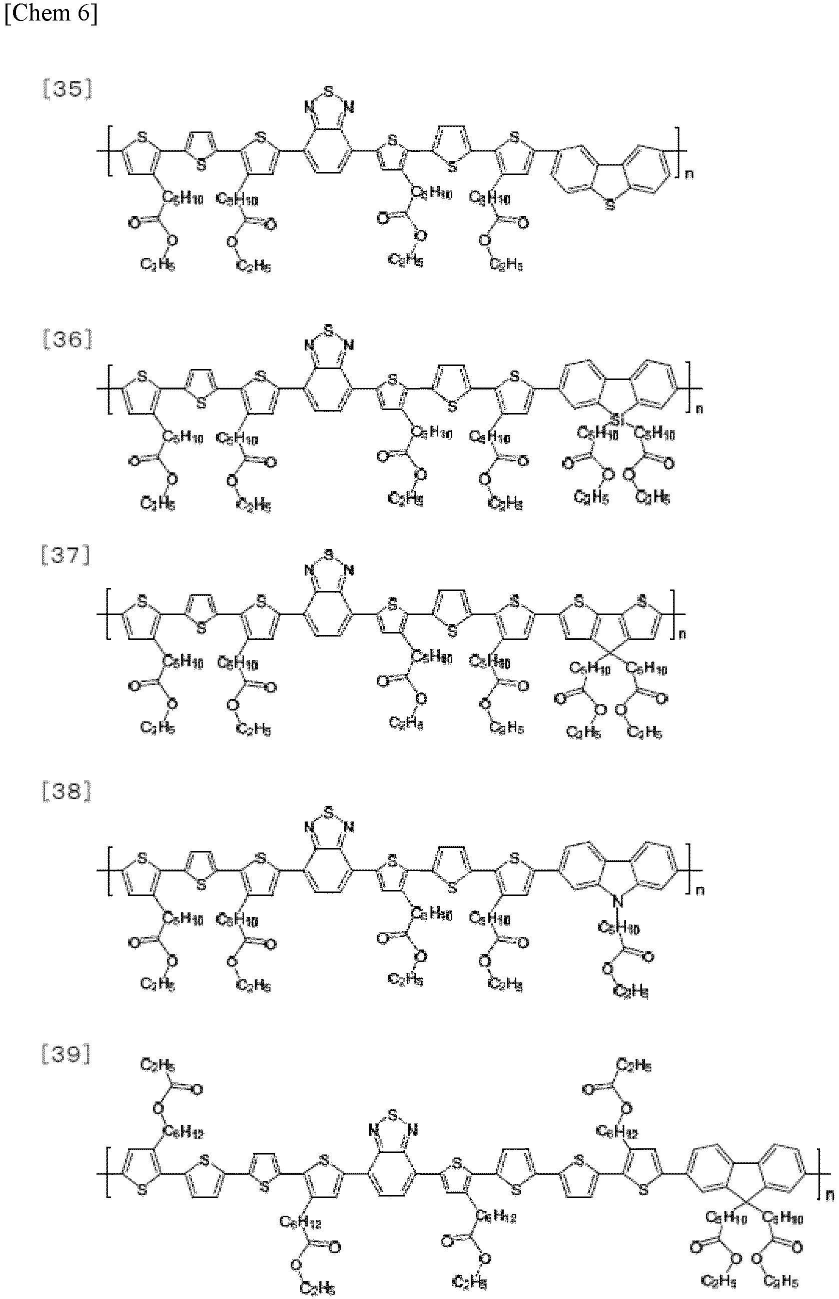

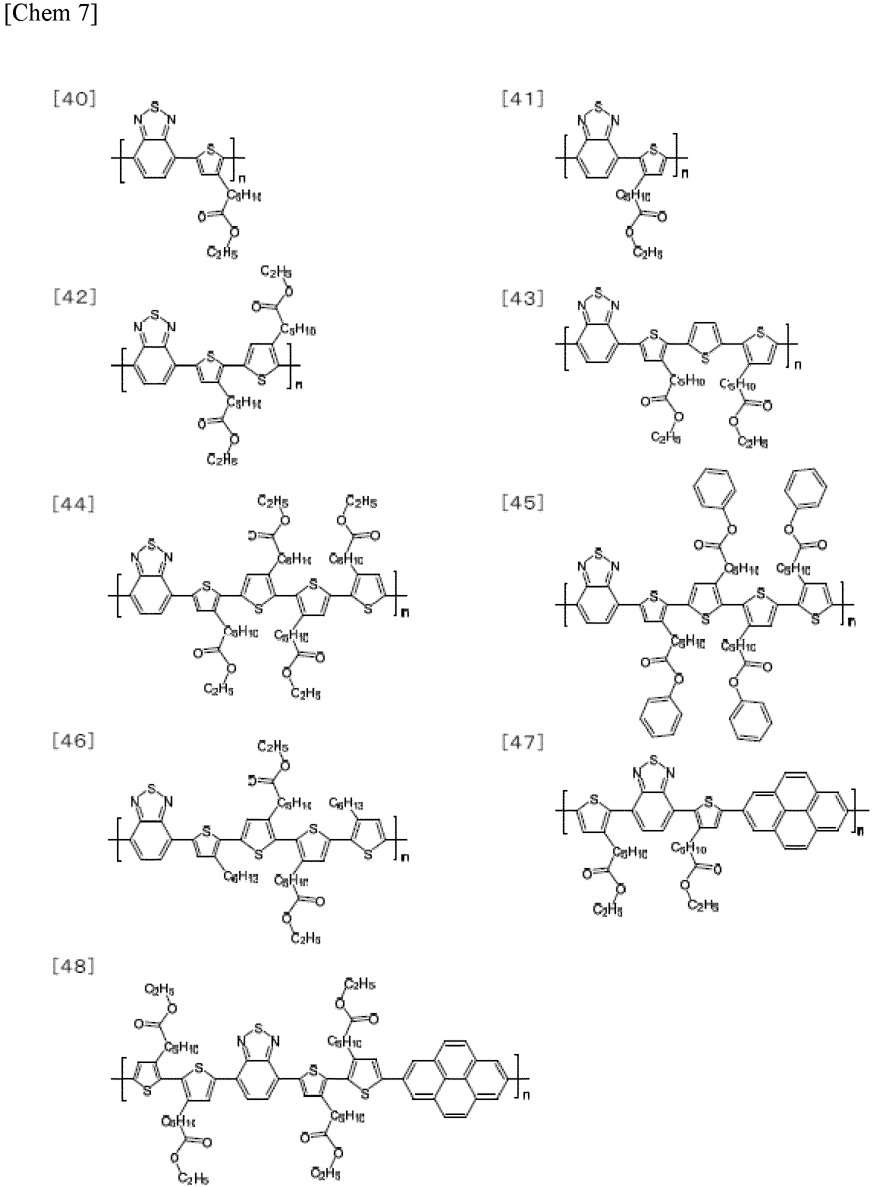

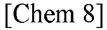

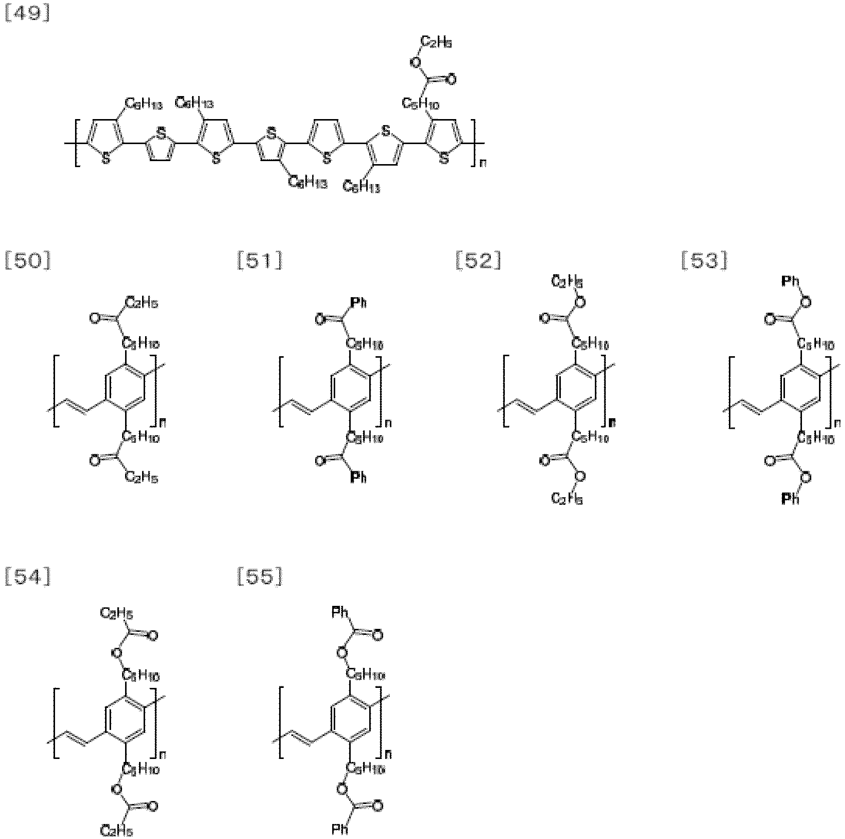

The side chain herein is a group bonded to the main chain of the conjugated polymer. The main chain of the conjugated polymer corresponds to a group having (1) a conjugated structure or (2) conjugated structures that are bound to each other to form a ring structure. Examples of (2) include a fluorene unit, and a carbon atom at the 9-position is also included in the main chain.

In the chemical formulas represented above as specific examples of the conjugated polymer, n represents the degree of polymerization of the conjugated polymer and is preferably in the range of 2 to 1,000. From the viewpoint of easy adhesion to CNTs, n is more preferably in the range of 3 to 500. In the present invention, the degree of polymerization n is a value obtained from the weight average molecular weight. The weight average molecular weight is measured by using GPC (gel permeation chromatography) and determined with a standard polystyrene sample. Further, from the viewpoint of easy adhesion to CNTs, the weight average molecular weight of the conjugated polymer is preferably 1,000 or more.

The ratio of the number of units having a side chain represented by the general formula (1) to the total number of units of the conjugated polymer[the number of units having a side chain represented by the general formula (1) / the total number of units of the conjugated polymer] is preferably 1/5 to 1/1. Within this range, the compatibility with a solvent having a suitable viscosity can be further improved.

The unit described herein is understood as a divalent group contained in the main chain of a conjugated polymer, such as a divalent group containing any one selected from the group consisting of an ethenylene group, an ethynylene group, an arylene group and a heteroarylene group. The number of units refers to the count number when each of the ethenylene group, ethynylene group, arylene group or heteroarylene group of the main chain in the repeating unit is counted as one unit. "The number of units having a side chain represented by the general formula (1)" refers to the number of units having a side chain represented by the general formula (1) and "the total number of units of the conjugated polymer" refers to the total number of units. For example, in the polymer[4],[the number of units having a side chain represented by the general formula (1) / the total number of units of the conjugated polymer] = 1/1; in the polymer[10],[the number of units having a side chain represented by the general formula (1) / the total number of units of the conjugated polymer] = 2/3; in the polymer[16],[the number of units having a side chain represented by the general formula (1) / the total number of units of the conjugated polymer] = 4/5; and in the polymer[53],[the number of units having a side chain represented by the general formula (1) / the total number of units of the conjugated polymer] = 1/2.

The conjugated polymer can be synthesized by a known method. Examples of the method of connecting thiophenes to each other include a method of coupling a thiophene halide and thiophene boronic acid or an ester of thiophene boronic acid under a palladium catalyst, and a method of coupling a thiophene halide and a thiophene Grignard reagent under a nickel or palladium catalyst. When the thiophene unit is connected with another unit, the halogenated unit and the thiophene unit can be coupled in the same manner. In addition, the monomer thus obtained is introduced with a polymerizable functional group at its terminal and the polymerization is proceeded under a palladium catalyst or a nickel catalyst. Thus, a conjugated polymer can be obtained.

The conjugated polymer is preferably used after impurities such as raw materials used in the synthesis process or by-products are removed. As a method of removing impurities, for example, a silica gel column chromatography method, a Soxhlet extraction method, a filtration method, an ion exchange method, a chelation method and the like can be used. Two or more of these methods can be combined.

Although the CNT composition described above can be used for various purposes, the CNT composition is preferably used in a semiconductor element. More specifically, the CNT composition described above is preferably used as a material for forming a semiconductor layer in a semiconductor element.

The structure of the semiconductor element to which the CNT composition as described above can be applied is not particularly limited and can be applied to the semiconductor element described in, for example, WO2009/116373, WO2017/130836, and the like.

The application of the above semiconductor element is not particularly limited, but the above semiconductor element is preferably used in a wireless communication device. A wireless communication device is a device that performs telecommunications such as RFID by receiving a carrier wave transmitted from an antenna mounted on a reader/writer with RFID tags. For example, the semiconductor element can be applied to the wireless communication device and a merchandise tag containing the wireless communication device, as described in WO2017/130836 and the like.

### EXAMPLES

The present invention will be described below in detail by way of Examples. However, the interpretation of the present invention is not limited to the following Examples.

### <Raw Material CNT Dispersion Liquid>

As raw material CNTs used in Examples, CNTs synthesized by the arc method and manufactured by Carbon Solutions (AP-SWNT, average diameter of 1.5 nm; catalog value) were purchased and used in Examples 1 and 4 to 7. In Examples 2 and 3, CNTs synthesized by the arc method and manufactured by Carbon Solutions (iP-SWNTs, average diameter of 1.5 nm) were purchased and used. For comparison, CNTs having a different diameter were synthesized and prepared by the gas phase flow method (see JP2018-016521A) (Comparative Example 1: average diameter of 1.8 nm, Comparative Example 2: average diameter of 1.2 nm).

In all of Examples 1 to 7 and Comparative Examples 1 and 2, CNTs and sodium cholate (SC) (manufactured by Wako Pure Chemical Industries, Ltd.) were mixed in water (purified water purified by distillation) at a sodium cholate concentration of 0.5% by mass and a CNT concentration of 0.1% by mass. Then, 100 g of the mixture was irradiated with ultrasonic waves at an output of 50% using an ultrasonic homogenizer (manufactured by Branson Ultrasonics, Ltd.: Digital Sonifier Models 250). The CNT dispersion liquid thus obtained was set in an ultracentrifugation separation machine (Hitachi, Ltd., himac CS100GXII) to precipitate and remove impurities mixed upon the synthesis of CNT. This resulting liquid was used as a raw material CNT dispersion liquid.

The irradiation time by the ultrasonic homogenizer was 3 hours for Examples 1 to 4 and Comparative Examples 1 and 2, 2.5 hours for Examples 5 to 6, and 2 hours for Example 7. The conditions of the ultracentrifugation were 50,000 G and 30 minutes for Examples 1 to 3 and 5 and Comparative Examples 1 and 2, and 40,000 G and 30 minutes for Examples 4 and 6 to 7.

### (Example 1)

### <Gel Column Method>

The raw material CNT dispersion liquid was subjected to separation by a gel column based on the method of Pattern 6 described above, and this was repeated twice as follows.

The conditions of Pattern 6 were as follows: the raw material CNT dispersion liquid was a CNT dispersion liquid having an SC concentration of 0.5% by mass. SDS was added so that the SDS concentration would be 0.5% by mass. Thus, a raw material CNT dispersion liquid 2 having an SC concentration of 0.5% by mass and an SDS concentration of 0.5% by mass was prepared. With reference to the method described in Patent Document 3, this raw material CNT dispersion liquid 2 was placed into a column filled with gel and eluted using as a mobile phase an aqueous solution having an SC concentration of 0.5% by mass and an SDS concentration of 0.5% by mass. After the metallic CNTs flowed out, the mobile phase was changed to an aqueous solution having an SC concentration of 0.5% by mass. Thus, a CNT dispersion liquid having a high ratio of the semiconducting CNTs was obtained. SDS was added to the resulting CNT dispersion liquid to adjust the SC concentration and SDS concentration to 0.5% by mass, and this CNT dispersion liquid was again introduced to the gel-filled column. Elution was again performed using as a mobile phase an aqueous solution having an SC concentration of 0.5% by mass and an SDS concentration of 0.5% by mass. After a trace of the mixed metallic CNTs flowed out, the mobile phase was changed to an aqueous solution having an SC concentration of 0.5% by mass. Thus, a CNT dispersion liquid having a higher ratio of the semiconducting CNTs was obtained.

### <Physical Properties of CNT Composition>

The CNT dispersion liquid obtained by the gel column method was directly measured for the absorption spectrum in the wavelength range of 300 nm to 1100 nm, using a spectrophotometer (JASCO V-770). The wavelength of the absorption peak top showing the maximum absorption was 1010 nm, and the wavelength of the minimum position was 664 nm. The ratio of the absorption intensity was 3.3.

The average CNT length measured by AFM was 0.53 µm. The length of CNT was measured by AFM as follows. The CNT dispersion liquid obtained by the gel column method was directly dropped onto a silicon substrate with the surface pretreated with (3-aminopropyl) triethoxysilane (APTES) and allowed to stand for 1 hour. The surface was then washed with water and dried at 100°C for about 30 minutes to prepare a sample. This sample was examined with a measurement field of 7 µm × 7 µm. All the CNTs isolated and dispersed in the field were counted, and the number was 151. The length of all these CNTs were measured and the arithmetic mean was calculated.

<Measurement of Value (D/G)×100 and Elemental Analysis>

The CNT dispersion liquid obtained by the gel column method was filtered under pressure using a membrane filter paper having a diameter of 0.1 µm (manufactured by Millipore Corp.). The CNT composition collected by filtration was washed twice with about 50 mL of methanol, twice with about 50 mL of water, and finally twice with about 50 mL of methanol. Then, a part the CNT composition was sampled for measurement, and dried on a slide glass at 120°C for 1 hour. The dried CNT product on the slide glass was examined with a Raman spectrophotometer at a wavelength of 532 nm. The value of (D/G)×100 was 66.

When a dry CNT sample obtained by the same method as the sample obtained for the measurement of the value of (D/G)×100 was examined for the XPS measurement, no halogen element could be detected.

### <Conjugated Polymers>

In Example 1, the polymer [28] was synthesized by the method shown in the following scheme (2).

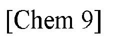

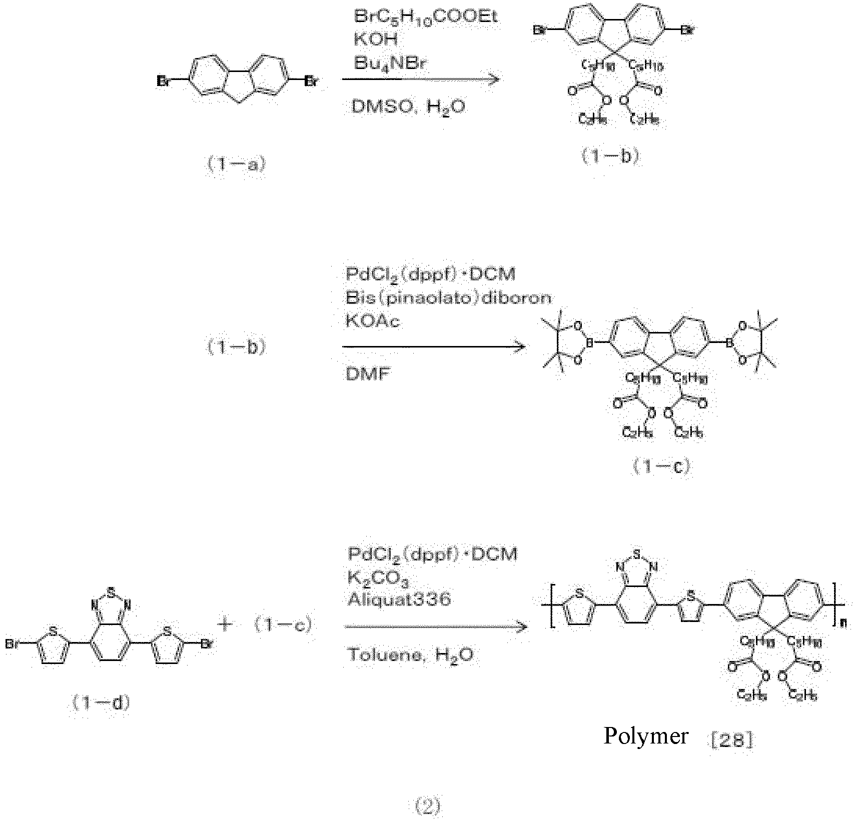

First, 1.6 g of the compound (1-a) (manufactured by Tokyo Chemical Industry Co., Ltd.) and 0.32 g of tetrabutylammonium bromide (manufactured by Tokyo Chemical Industry Co., Ltd.) were dissolved in 10.0 mL of dimethyl sulfoxide (manufactured by Wako Pure Chemical Industries, Ltd.). Then, 0.76 mL of an aqueous solution of 0.76 g of potassium hydroxide (manufactured by Wako Pure Chemical Industries, Ltd.) was added under a nitrogen atmosphere, and the mixture was stirred at room temperature for 30 minutes. Ethyl 6-bromohexanoate was added to the obtained solution, and the mixture was stirred at 50°C for 6 hours. To the obtained solution, 100 mL of water, 100 mL of n-hexane and 100 mL of dichloromethane were added, and the organic layer was collected. The organic layer thus obtained was washed with 100 mL of water and then dried over magnesium sulfate. The obtained solution was purified by column chromatography (filler: silica gel, eluent: toluene) to obtain 1.5 g of the compound (1-b).

Then, 1.2 g of the compound (1-b), 1.5 g of bispinacolato diboron (manufactured by Tokyo Chemical Industry Co., Ltd.), 0.79 g of potassium acetate (manufactured by Tokyo Chemical Industry Co., Ltd.), and 74 mg of [1,1'-bis(diphenylphosphino)ferrocene]palladium (II) dichloride dichloromethane adduct were dissolved in 15.0 mL of dimethylformamide and stirred at 100°C for 12 hours under a nitrogen atmosphere. To the obtained solution, 200 mL of water, 200 mL of n-hexane and 200 mL of dichloromethane were added, and the organic layer was collected. The organic layer thus obtained was washed with 200 mL of water and then dried over magnesium sulfate. The obtained solution was purified by column chromatography (filler: silica gel, eluent: toluene/ethyl acetate) to obtain 0.84 g of the compound (1-c).

Then, 0.42 g of the compound (1-c) and 0.23 g of the compound (1-d) were dissolved in 30 mL of toluene. To this mixture, 10 mL of water, 0.65 g of potassium carbonate, 19 mg of[1,1'-bis(diphenylphosphino)ferrocene]palladium (II) dichloride dichloromethane adduct (manufactured by Tokyo Chemical Industry Co., Ltd.), and one drop of Aliquat (R) 336 (manufactured by Aldrich Co., Ltd.) were added, and the mixture was stirred at 80°C for 1 hour under a nitrogen atmosphere. Then, 0.64 g of bromobenzene was added, and the mixture was stirred at 80°C for 30 minutes. To the obtained solution, 50 mL of methanol was added. The solid which was produced was collected by filtration and washed with methanol, water, methanol and acetone in this order. The obtained solid was dissolved in chloroform, passed through a silica gel short column (eluent: chloroform/ethyl acetate), and then concentrated to dryness to obtain 0.27 g of the polymer[28]. When the molecular weight of the polymer[28] was measured by the following method, the weight average molecular weight was 20,768 and the number average molecular weight was 12,980.

The molecular weight of the conjugated polymer was measured as follows. After the sample was filtered with a membrane filter having a pore size of 0.45 µm, the sample was subjected to GPC (Gel Permeation Chromatography, HLC-8220 GPC manufactured by Tosoh Corporation) (mobile phase: chloroform or tetrahydrofuran, flow rate: 0.4 mL/min). The molecular weight was determined, using a polystyrene standard sample.

### <Inkjet Coating>

The inkjet coating of the CNT dispersion liquid was performed using an inkjet device (manufactured by Toray Engineering Co., Ltd.).

### <Mobility>

The mobility was evaluated as follows. A semiconductor element was prepared using a CNT dispersion liquid. The semiconductor element was examined for the source-drain current (Id) and-source-drain voltage (Vsd) characteristics when the gate voltage (Vg) was changed. The evaluation system of semiconductor characteristics, 4200-SCS (manufactured by Keithley Instruments) was used for the measurement. The measurement was performed in the atmosphere. The mobility of the linear region was determined from the variation in the value of Id at Vsd = + 5V when Vg was changed from +20V to -20V.

### <Production Examples of Composite of Conjugated Polymer and CNT>

The CNT dispersion liquid obtained by the gel column method was filtered under pressure using a membrane filter paper having a diameter of 0.1 µm (manufactured by Millipore Corp.). The CNT composition collected by filtration was washed twice with about 50 mL of methanol, twice with about 50 mL of water, and finally twice with about 50 mL of methanol, to obtain a methanol wet cake. Then, 1.0 mg of the cake was added to 10 mL of a chloroform solution of 5.0 mg of the polymer [28]. While cooling with ice, the mixture was ultrasonically stirred for 2 hours at an output of 40% using an ultrasonic homogenizer (VCX-500 manufactured by Tokyo Rikakikai Co., Ltd.). Thus, a CNT dispersion liquid 1 (the concentration of CNT composite was 0.1 g/L with respect to the solvent).

Then, the CNT dispersion liquid 1 was filtered using a membrane filter (pore diameter of 10 µm, diameter of 25 mm, omnipore membrane manufactured by Millipore Corp.). After 5 mL of dichlorobenzene was added to the obtained filtrate, the chloroform, which was a low boiling point solvent, was distilled off using a rotary evaporator. Thus, a CNT dispersion liquid A (the concentration of the CNT composite was 0.1 g/L with respect to the solvent) was obtained.

### <Production Examples of Gate-insulating Layer Solution>

First, 61.29 g (0.45 mol) of methyltrimethoxysilane, 12.31 g (0.05 mol) of 2-(3,4-epoxycyclohexyl)ethyltrimethoxysilane, and 99.15 g (0.5 mol) of phenyltrimethoxysilane were dissolved in 203.36 g of propylene glycol monobutyl ether (boiling point of 170°C), and 54.90 g of water and 0.864 g of phosphoric acid were added to this mixture under stirring. The obtained solution was heated at a bath temperature of 105°C for 2 hours to raise the internal temperature to 90°C, and a component mainly composed of methanol produced as a by-product was distilled off. Then, the obtained solution was heated at a bath temperature of 130°C for 2.0 hours to raise the internal temperature to 118°C, and a component mainly composed of water and propylene glycol monobutyl ether was distilled off. Then the mixture was cooled to room temperature to obtain a polysiloxane solution A having a solid content concentration of 26.0% by mass. The molecular weight of the obtained polysiloxane was measured by the method as described above, and the weight average molecular weight was 6,000.

Then, 10 g of the obtained polysiloxane solution A, 13.0 g of aluminum bis(ethylacetocetate)mono(2,4-pentanedionate) (trade name "Aluminum Chelate D", manufactured by Kawaken Fine Chemicals Co., Ltd., hereinafter referred to as Aluminum Chelate D) and 42.0 g of propylene glycol monoethyl ether acetate (hereinafter referred to as PGMEA) were mixed and stirred at room temperature for 2 hours to obtain a gate-insulating layer solution A. The content of the polysiloxane in this solution was 20 parts by mass with respect to 100 parts by mass of the aluminum chelate D.

### <Production Examples of Semiconductor Element>

The semiconductor element shown in Fig. 1 was manufactured. A gate electrode 2 was formed by vacuum-deposition of chromium at a thickness of 5 nm and gold at a thickness of 50 nm on a glass substrate 1 (thickness of 0.7 mm) through a mask by a resistance heating method. The gate-insulating layer solution A was then spin-coated on the substrate (2000 rpm x 30 seconds) and thermally treated at 200°C for 1 hour under a nitrogen gas stream. Thus, a gate-insulating layer 3 having a film thickness of 600 nm was obtained. Then a source electrode 5 and a drain electrode 6 were formed by vacuum-deposition of gold at a thickness of 50 nm through a mask by a resistance heating method. Then the CNT dispersion liquid A was inkjet-coated between the source electrode 5 and the drain electrode 6 by the method as described above, and thermally treated at 180°C for 30 minutes under a nitrogen gas stream to form the semiconductor layer 4. In this way, a semiconductor element was obtained. The width (channel width) of the source electrode 5 and the drain electrode 6 of this semiconductor element was 100 µm each, and the distance (channel length) between the source electrode 5 and the drain electrode 6 was 10 µm.

When the mobility of the semiconductor element was evaluated by the method as described above, the mobility was 40.0 cm²/Vs when the ratio of on-current to off-current (on/off ratio) was 2.0E + 06.

### <Example 2>

The same operation as in Example 1 was carried out except that the raw material CNTs were changed as mentioned above and the elution method of Pattern 6 by the gel column method was performed once.

The results are shown in Table 1. The mobility shows a value at an on/off ratio of 2.0E + 06.

### <Example 3>

The same operation as in Example 1 was carried out except that the raw material CNTs were changed as mentioned above and the elution method by the gel column method was changed to Pattern 7. The results are shown in Table 1. The mobility shows a value at an on/off ratio of 2.0E + 06.

### <Examples 4 to 7>

The same operation as in Example 1 was carried out except that the combination of the irradiation time by the ultrasonic homogenizer and the conditions for centrifugation was different as described in Raw Material CNT Dispersion Liquid. The results are shown in Table 1. The mobility shows a value at an on/off ratio of 2.0E + 06.

### <Comparative Examples 1 and 2>

Using two types of CNTs which were synthesized by the gas phase flow method and had different diameter distributions, a CNT composition from which the metallic CNTs were removed by the gel column method in the same manner as in Example 1 was obtained. This CNT composition was examined to measure the light absorption, (D/G)x100 value, and subjected to elemental analysis. Furthermore, a semiconductor element was manufactured, and the mobility was measured. The results are shown in Table 1. The mobility shows a value at an on/off ratio of2.0E + 06.

**[Table 1]**

| | Position of maximum absorption peak (nm) | Position of minimum absorption peak (nm) | Ratio of absorption intensity | Value of (D/G)×100 | Elemental analysis | CNT average length (µm) | Mobility (cm²/Vs) |
|---|---|---|---|---|---|---|---|
| Example 1 | 1010 | 664 | 3.3 | 1.52 | No halogen | 0.53 | 40.0 |
| Example 2 | 999 | 659 | 2.9 | 2.44 | No halogen | 0.51 | 36.4 |
| Example 3 | 1003 | 654 | 2.6 | 2.44 | No halogen | 0.51 | 21.0 |
| Example 4 | 1013 | 667 | 3.6 | 1.20 | No halogen | 0.71 | 44.9 |
| Example 5 | 1013 | 667 | 3.4 | 1.09 | No halogen | 0.60 | 50.3 |
| Example 6 | 1015 | 652 | 3.7 | 1.06 | No halogen | 0.85 | 63.2 |
| Example 7 | 1012 | 651 | 3.3 | 1.21 | No halogen | 1.43 | 55.7 |
| Comparative Example 1 | 1078 | 738 | 2.3 | 6.25 | No halogen | 0.33 | 2.3 |
| Comparative Example 2 | 850 | 590 | 2.3 | 3.70 | No halogen | 0.40 | 15.3 |

### DESCRIPTION OF THE REFERENCE NUMERALS

- 1: Substrate
- 2: Gate Electrode
- 3: Gate-insulating Layer
- 4: Semiconductor Layer
- 5: Source Electrode
- 6: Drain Electrode
- 7: CNT Composite

## Claims

1. A halogen-free carbon nanotube composition comprising a carbon nanotube having the following features (1) and (2):
(1) a dispersion liquid obtained by dispersing said carbon nanotube in a solution containing a cholic acid derivative and water has, in the absorption spectrum in the wavelength range of 300 nm to 1100 nm measured by an ultraviolet/visible/near-infrared spectrophotometer, the minimum absorbance (εₘᵢₙ) in the wavelength range of 600 nm to 700 nm and the maximum absorbance (εₘₐₓ) in the wavelength range of 900 nm to 1050 nm, wherein the ratio of said minimum absorbance and said maximum absorbance (εₘₐₓ/εₘᵢₙ) is 2.5 or more and 4.5 or less; and
(2) said dispersion liquid has the height ratio of the G-band and the D-band (value of (D/G)×100) of 3.33 or less, as measured by a Raman spectrophotometer, using light having a wavelength of 532 nm as excitation light.

2. The carbon nanotube composition according to claim 1, wherein the average length of said carbon nanotube is 0.5 µm to 2 µm.

3. The carbon nanotube composition according to claim 1 or 2, wherein said carbon nanotube is a carbon nanotube composite in which a conjugated polymer is attached to at least a part of the surface of said carbon nanotube.

4. The carbon nanotube composition according to claim 3, wherein said conjugated polymer has a side chain represented by the general formula (1): 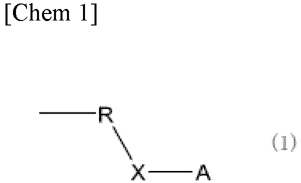 (wherein, in the general formula (1), R is an alkylene group or a cycloalkylene group; X is a single bond, an alkenylene group, an alkynylene group, an arylene group or a heteroarylene group; and A is an alkyl carbonyl group, an aryl carbonyl group, a heteroaryl carbonyl group, an alkoxy carbonyl group, an aryloxy carbonyl group, a heteroaryloxy carbonyl group, an alkyl carbonyloxy group, an aryl carbonyloxy group or a heteroaryl carbonyloxy group.)

5. A semiconductor element comprising the carbon nanotube composition according to any one of claims 1 to 4.

6. A wireless communication device comprising the semiconductor element according to claim 5.
